# EUROPEAN PATENT APPLICATION

(11) **EP 3 748 221 A1**
(43) Date of publication of application: **09.12.2020**
(21) Application number: 19748048.6
(22) Date of filing: 23.01.2019
(51) Int. Cl.: F21S 2/00, G02B 6/00, H01L 33/58, H01L 33/60, F21Y 105/00, F21Y 115/10

(54) **LED BACKLIGHT FILM AND LED BACKLIGHT**

(30) Priority: 02.02.2018 JP 2018017206
(71) Applicant: Nitto Denko Corporation, Ibaraki-shi, Osaka 567-8680 (JP)
(72) Inventor: HATTORI, Daisuke, Ibaraki-shi, Osaka 567-8680 (JP); NAKAMURA, Kozo, Ibaraki-shi, Osaka 567-8680 (JP); KISHI, Atsushi, Ibaraki-shi, Osaka 567-8680 (JP)
(74) Representative: Hoffmann Eitle
(86) International application number: PCT/JP2019/002036
(87) International publication number: WO 2019/151073

(57) **Abstract**

Provided is a film for an LED backlight, which can enhance the waveguide efficiency of a light guide plate in a sidelight-type planar backlight. The film for an LED backlight of the present invention includes: a low-refractive index layer; and a first pressure-sensitive adhesive layer arranged on at least one side of the low-refractive index layer, wherein the low-refractive index layer has a refractive index of 1.25 or less. In one embodiment, the low-refractive index layer is configured to be a porous body having voids. In one embodiment, the low-refractive index layer has a void ratio of 35 vol% or less.

## Description

### Technical Field

The present invention relates to a film for an LED backlight and an LED backlight using the same.

### Background Art

Liquid crystal displays for displaying images are widely adopted in portable terminals, personal computers, car navigation systems, televisions, and the like. In the liquid crystal display, frequent use is made of a planar backlight, which is arranged on a back surface side of a liquid crystal display panel, and is configured to emit planar light.

Among the planar backlights, a sidelight-type planar backlight is often adopted, in which a light source is arranged on a side end surface (hereinafter referred to as entrance surface) of a light guide plate, and light that has entered through the entrance surface is emitted from a main surface (hereinafter referred to as emission surface) of the light guide plate. In such planar light unit, it is a general task to improve waveguide efficiency in the light guide plate, lightness uniformity in the emission surface, and the like.

### Citation List

### Patent Literature

[PTL 1] JP 2012-114284 A

### Summary of Invention

### Technical Problem

An object of the present invention is to provide a film for an LED backlight, which can enhance the waveguide efficiency and lightness uniformity of a light guide plate in a sidelight-type planar backlight.

### Solution to Problem

According to one embodiment of the present invention, there is provided a film for an LED backlight, including: a low-refractive index layer; and a first pressure-sensitive adhesive layer arranged on at least one side of the low-refractive index layer, wherein the low-refractive index layer has a refractive index of 1.25 or less.

In one embodiment, the low-refractive index layer is configured to be a porous body having voids.

In one embodiment, the low-refractive index layer has a void ratio of 35 vol% or less.

In one embodiment, the film for an LED backlight has a thickness of 100 µm or less.

According to another embodiment of the present invention, there is provided a light guide unit. The light guide unit includes: the above-mentioned film for an LED backlight; and a light guide plate, wherein the film for an LED backlight is bonded to the light guide plate so as to cover part of one surface of the light guide plate in a light guiding direction of the light guide plate, and so as to cover an entirety of the one surface of the light guide plate in a direction perpendicular to the light guiding direction.

According to still another embodiment of the present invention, there is provided an LED backlight. The LED backlight includes: the above-mentioned light guide unit; and an LED light source arranged on the end surface of the light guide plate on a side on which the film for an LED backlight is arranged.

In one embodiment, the film for an LED backlight has a thickness of from {(thickness of LED light source-thickness of light guide plate)×50%} to { (thickness of LED light source-thickness of light guide plate)×100%}.

### Advantageous Effects of Invention

The film for an LED backlight of the present invention includes the low-refractive index layer having a refractive index of 1.25 or less. The use of the film for an LED backlight can enhance the waveguide efficiency and lightness uniformity of a light guide plate in a sidelight-type planar backlight.

### Brief Description of Drawings

FIG. **1** is a schematic cross-sectional view of a film for an LED backlight according to one embodiment of the present invention.
FIG. **2 (a)** is a schematic cross-sectional view of a light guide unit according to one embodiment of the present invention, and FIG. **2(b)** is a schematic plan view of the light guide unit of FIG. **2 (a)** .
FIG. 3 is a schematic cross-sectional view of an LED backlight according to one embodiment of the present invention.

### Description of Embodiments

### A. Film for LED Backlight

### A-1. Outline of Film for LED Backlight

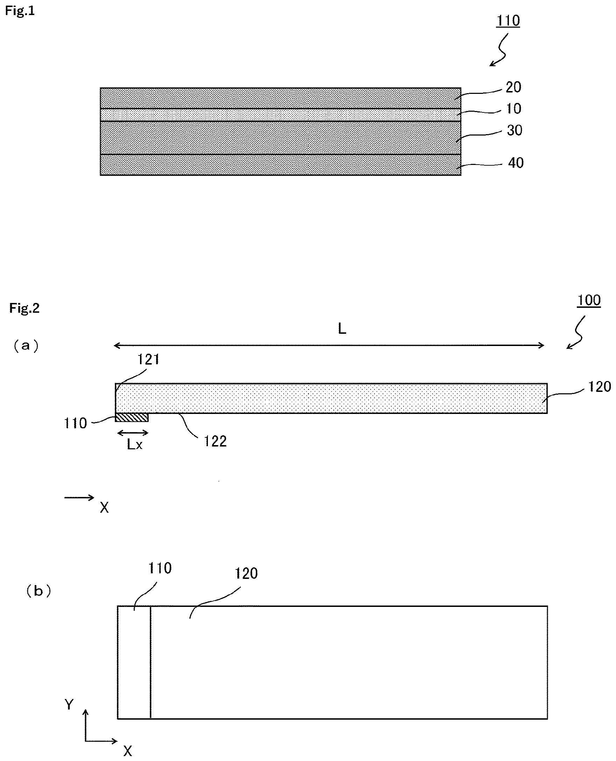

FIG. **1** is a schematic cross-sectional view of a film for an LED backlight according to one embodiment of the present invention. A film **110** for an LED backlight according to this embodiment includes a low-refractive index layer **10** and a first pressure-sensitive adhesive layer **20** arranged on at least one side of the low-refractive index layer **10.** The low-refractive index layer **10** has a refractive index of 1.25 or less. The film **110** for an LED backlight may further include a base material **30** as required. In one embodiment, when the film **110** for an LED backlight includes the base material **30,** the first pressure-sensitive adhesive layer **20,** the low-refractive index layer **10,** and the base material **30** are arranged in the stated order. In one embodiment, the base material **30** is arranged so as to be peelable from the low-refractive index layer **10.** The film **110** for an LED backlight further includes a second pressure-sensitive adhesive layer **40** as required. In one embodiment, when the film **110** for an LED backlight includes the second pressure-sensitive adhesive layer **40,** the first pressure-sensitive adhesive layer **20,** the low-refractive index layer **10,** the base material **30,** and the second pressure-sensitive adhesive layer **40** are arranged in the stated order. Herein, for ease of viewing, each constituent member in the drawings is schematically illustrated, and the size and/or scale thereof in the illustration is different from the actual size and/or scale thereof.

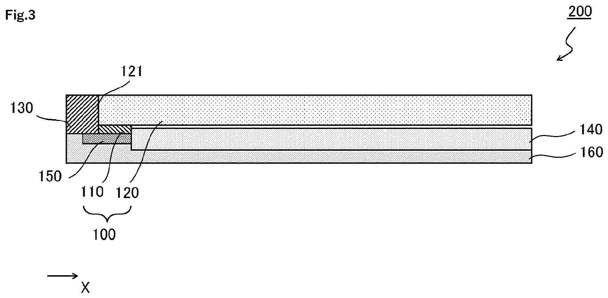

The film for an LED backlight is used for a light guide plate and forms a light guide unit together with the light guide plate. FIG. **2(a)** is a schematic cross-sectional view of a light guide unit according to one embodiment of the present invention, and FIG. **2(b)** is a schematic plan view of the light guide unit of FIG. **2(a).** FIG. **2(b)** is a view of a light guide unit **100** of FIG. **2(a)** seen from below (lower side of the drawing sheet) . The light guide unit **100** includes the film **110** for an LED backlight and a light guide plate **120.** The film **110** for an LED backlight of the present invention may be used by being bonded to part of a main surface of the light guide plate **120.** More specifically, the film **110** for an LED backlight may be used by being bonded in the vicinity of an end surface **121** of the light guide plate **120** in its light guiding direction (end surface **121** on which a light source is to be arranged) . The **film 110** for a LED backlight film may be preferably used by being bonded to the light guide plate **120** so as to cover part of one surface of the light guide plate **120** in a light guiding direction **X,** and so as to cover the entirety of the one surface of the light guide plate **120** in a direction **Y** perpendicular to the light guiding direction **X** in a plane including the light guiding direction **X.** The film **110** for an LED backlight may be bonded in such a manner that the light guide plate **120** and the low-refractive index layer **10** are arranged via the first pressure-sensitive adhesive layer **20.** The film **110** for an LED backlight is preferably directly arranged on the light guide plate. In addition, when the film **110** for an LED backlight includes the base material **30,** the film **110** for an LED backlight is preferably directly arranged in such a manner that the low-refractive index layer **10** is arranged inside (light guide plate side) with respect to the base material **30.** The light guide unit **100** may be applied to a sidelight-type planar backlight. For example, the light guide unit **100** may be used with an LED light source **130** being arranged on the end surface **121** of the light guide plate **120,** and constitute an LED backlight **200** together with the LED light source **130** (FIG. **3**). As used herein, the term "light guiding direction" means a direction perpendicular to the end surface on which the light source is to be arranged.

When the film for an LED backlight of the present invention is used as described above, the light guide plate can be fixed to the main body of the LED backlight. In addition, light can be satisfactorily reflected at an interface between the light guide plate and the film for an LED backlight, and hence an improvement in waveguide efficiency of light can be achieved. When light is satisfactorily reflected in the vicinity of the entrance surface, the emitted light intensity of the light guide plate as a whole can be enhanced. Further, when the film for an LED backlight of the present invention is used as described above, light leakage in the vicinity of the entrance surface of the light guide plate and unevenness in lightness can be prevented. Further, through adjustment of the thickness of the film for an LED backlight, positioning of the light guide plate can be performed, and hence a positional relationship between the LED light source and the light guide plate can be easily made proper.

The thickness of the film for an LED backlight is preferably 120 µm or less, more preferably 110 µm or less, still more preferably 100 µm or less, particularly preferably 60 µm or less. When the thickness falls within such ranges, in the application of the film for an LED backlight to a backlight, the positional relationship between the LED light source and the light guide plate can be appropriately adjusted. The thickness of the film for an LED backlight may be set to an appropriate thickness depending on the form of the backlight to which the film for an LED backlight is applied. The lower limit of the thickness of the film for an LED backlight is, for example, 10 µm.

The film for an LED backlight has a heat resistance of preferably 60°C or more, more preferably 80°C or more. When the heat resistance falls within such ranges, there can be obtained a film for an LED backlight, which is suited for use in the vicinity of an LED light source and can satisfactorily maintain the above-mentioned effect. The "heat resistance" means that, when the film for an LED backlight is placed in an oven at 60° or 80°C or more for 300 hours or more, changes in characteristics (emitted light quantity, directivity, and adhesion strength for a layer with which the film for an LED backlight is brought into direct contact) after the placement in the oven as compared to those therebefore fall within ranges in which use for an LED backlight is not affected.

### A-2. Low-refractive Index Layer

As described above, the low-refractive index layer has a refractive index of 1.25 or less. When a film for an LED backlight including a low-refractive index layer having such refractive index is laminated on the light guide plate, there can be obtained an LED backlight capable of satisfactorily reflecting light at the interface between the light guide plate and the film for an LED backlight, thereby being excellent in waveguide efficiency of light and excellent in emission intensity. The refractive index of the low-refractive index layer is preferably 1.20 or less, more preferably 1.18 or less, still more preferably 1.15 or less. The refractive index of the low-refractive index layer is preferably as low as possible, but the lower limit thereof is, for example, 1.07 or more (preferably 1.05 or more). As used herein, the term "refractive index" refers to a refractive index measured at a wavelength of 550 nm.

The thickness of the low-refractive index layer is preferably from 0.01 µm to 100 µm, more preferably from 0.05 µm to 70 µm, still more preferably from 0.1 µm to 48 µm, particularly preferably from 0.3 µm to 40 µm, most preferably from 0.3 µm to 30 µm.

The low-refractive index layer may have any appropriate form as long as its refractive index falls within the above-mentioned ranges. In one embodiment, the low-refractive index layer is configured to be a porous body having predetermined voids.

The void ratio of the low-refractive index layer configured to be a porous body is preferably from 5 vol% to 95 vol%, more preferably from 15 vol% to 95 vol%, still more preferably from 25 vol% to 90 vol%, still more preferably from 35 vol% to 90 vol%, particularly preferably from 38 vol% to 85 vol%, most preferably from 40 vol% to 80 vol%. When the void ratio falls within such ranges, a low-refractive index layer having a particularly low refractive index can be formed. When the layer to be subjected to the measurement of the void ratio is merely a single layer containing voids, a ratio (volume ratio) between a material forming the layer and air may be calculated by a conventional method (involving, for example, measuring the weight and volume of the layer and calculating the density thereof), and hence the void ratio (vol%) may be thus calculated. In addition, the refractive index and the void ratio correlate with each other, and hence, for example, the void ratio may also be calculated from the value of the refractive index as a layer. Specifically, for example, the void ratio is calculated by Lorentz-Lorenz's formula from the value of the refractive index measured with an ellipsometer.

The size of each of the voids is preferably from 2 nm to 500 nm, more preferably from 5 nm to 500 nm, still more preferably from 10 nm to 200 nm, particularly preferably from 20 nm to 100 nm. The size of each of the voids may be measured by a BET test method. Specifically, the void size may be evaluated from a pore distribution obtained by: loading 0.1 g of a low-refractive index layer sample into a capillary of a specific surface area measurement apparatus (product name: "ASAP2020", manufactured by Micromeritics Instrument Corporation); then removing gas in its void structure through drying under reduced pressure at room temperature for 24 hours; and then adsorbing a nitrogen gas onto the low-refractive index layer sample.

The peak pore diameter of the low-refractive index layer configured to be a porous body is preferably from 5 nm to 50 nm, more preferably from 10 nm to 40 nm, still more preferably from 20 nm to 30 nm. The peak pore diameter is determined from a BJH plot and a BET plot, and an isothermal adsorption curve, each of which is based on nitrogen adsorption, through use of a pore distribution/specific surface area measurement apparatus (product name: "BELLSORP MINI", from MicrotracBEL Corp.).

The low-refractive index layer configured to be a porous body contains, for example, approximately spherical particles, such as silicone particles, silicone particles having fine pores, or silica hollow nanoparticles, fibrous particles, such as a cellulose nanofiber, an alumina nanofiber, or a silica nanofiber, or flat plate-like particles, such as nanoclay formed of bentonite. In one embodiment, the low-refractive index layer configured to be a porous body is a porous body formed by chemical bonding between particles. In addition, at least some of the particles forming the low-refractive index layer configured to be a porous body may be bonded to each other via a small amount of a binder component (e.g., a binder component having a weight equal to or smaller than that of the particles). The void ratio and refractive index of the low-refractive index layer configured to be a porous body may be adjusted on the basis of, for example, the particle diameters and particle diameter distribution of the particles forming the low-refractive index layer.

As a method of obtaining the low-refractive index layer configured to be a porous body, there are given, for example, methods described in JP 2010-189212 A, JP 2008-040171 A, JP 2006-011175 A, WO 2004/113966 A1, and references thereof. Specific examples thereof include: a method involving hydrolyzing and polycondensing at least one of a silica-based compound, or a hydrolyzable silane, or a partial hydrolysate or dehydration condensate thereof; a method involving using porous particles and/or hollow fine particles; a method involving utilizing a spring-back phenomenon to produce an aerogel layer; and a method involving using a pulverized gel, which is obtained by pulverizing a gel obtained by a sol-gel method and chemically bonding fine porous particles in the pulverized liquid to each other with a catalyst or the like. However, the low-refractive index layer may be produced by any production method, which is not limited to the above-mentioned production methods.

The low-refractive index layer is preferably a silicone porous body. The silicone porous body may be formed of fine porous particles of a silicon compound that are bonded to each other. An example of the fine porous particles of a silicon compound is a pulverized product of a gelled silicon compound. The silicone porous body may be formed by, for example, applying an application liquid containing the pulverized product of a gelled silicon compound to a base material. In one embodiment, the pulverized product of a gelled silicon compound may be subjected to, for example, the action of a catalyst, light irradiation, or heating, to form a chemical bond (e.g., a siloxane bond).

An example of the silicon compound is a compound represented by the following formula (1).

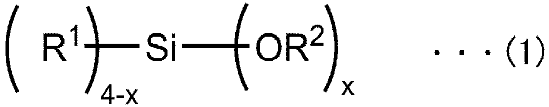

In the formula (1), X represents 2, 3, or 4. R¹ represents preferably a linear or branched alkyl group having 1 to 6 carbon atoms, more preferably a linear or branched alkyl group having 1 to 4 carbon atoms, still more preferably an alkyl group having 1 or 2 carbon atoms. R² represents preferably a hydrogen atom or a linear or branched alkyl group having 1 to 6 carbon atoms, more preferably a hydrogen atom or a linear or branched alkyl group having 1 to 4 carbon atoms, still more preferably a hydrogen atom or an alkyl group having 1 or 2 carbon atoms.

Specific examples of the silicon compound include tris(hydroxy)methylsilane and trimethoxy(methyl)silane.

In one embodiment, the silicon compound is a trifunctional silane. When the trifunctional silane is used, a low-refractive index layer having a particularly low refractive index can be formed. In another embodiment, the silicon compound is a tetrafunctional silane. When the tetrafunctional silane is used, a low-refractive index layer excellent in scratch resistance can be formed.

The gelation of the silicon compound may be performed by, for example, a dehydration condensation reaction of the silicon compound. Any appropriate method may be adopted as a method for the dehydration condensation reaction.

Any appropriate method may be adopted as a pulverization method for the gelled silicon compound. An example of the pulverization method is a method involving using a pulverization apparatus making use of a cavitation phenomenon, such as an ultrasonic homogenizer or a high-speed rotating homogenizer.

The volume-average particle diameter of the fine porous particles of a silicon compound (pulverized product of a gelled silicon compound) is preferably from 0.1 µm to 2 µm, more preferably from 0.2 µm to 1.5 µm, still more preferably from 0.4 µm to 1 µm. The volume-average particle diameter may be measured by a dynamic light scattering method.

With regard to the particle size distribution of the fine porous particles of a silicon compound (pulverized product of a gelled silicon compound), the ratio of particles each having a particle diameter of from 0.4 µm to 1 µm to all particles is preferably from 50 wt% to 99.9 wt%, more preferably from 80 wt% to 99.8 wt%, still more preferably from 90 wt% to 99.7 wt%. In addition, the ratio of particles each having a particle diameter of from 1 µm to 2 µm to all particles is preferably from 0.1 wt% to 50 wt%, more preferably from 0.2 wt% to 20 wt%, still more preferably from 0.3 wt% to 10 wt%. The particle size distribution may be measured with a particle size distribution evaluation apparatus.

### A-3. Base Material

The base material may be formed of any appropriate material. As a material for forming the base material, there are given, for example: thermoplastic resins, such as a polyethylene terephthalate-based resin, an acrylic resin, a cellulose-based resin, a cycloolefin-based resin, and an olefin-based resin; thermosetting resins; inorganic materials, such as glass and silicon; and carbon fiber materials.

The thickness of the base material is not particularly limited, and may be set to any appropriate thickness depending on applications. The thickness of the base material is, for example, from 1 µm to 100 µm, preferably from 1 µm to 60 µm, more preferably from 2 µm to 40 µm.

The base material may be transparent, or may be non-transparent. In one embodiment, the base material is transparent. When the base material is transparent, its transmittance is preferably from 50% to 99%, more preferably from 60% to 99%, still more preferably from 70% to 99%. When the transmittance falls within such ranges, there can be obtained a film for an LED backlight, which can enable appropriate guiding of light, even in the case where light leakage to the base material occurs.

### A-4. First Pressure-sensitive Adhesive Layer

The first pressure-sensitive adhesive layer contains any appropriate pressure-sensitive adhesive. The pressure-sensitive adhesive preferably has transparency and optical isotropy. Specific examples of the pressure-sensitive adhesive include a rubber-based pressure-sensitive adhesive, an acrylic pressure-sensitive adhesive, a silicone-based pressure-sensitive adhesive, an epoxy-based pressure-sensitive adhesive, and a cellulose-based pressure-sensitive adhesive. Of those, a rubber-based pressure-sensitive adhesive or an acrylic pressure-sensitive adhesive is preferred.

In one embodiment, the acrylic pressure-sensitive adhesive is used as the pressure-sensitive adhesive. An example of the acrylic pressure-sensitive adhesive is an acrylic pressure-sensitive adhesive including as a base polymer an acrylic polymer (homopolymer or copolymer) containing a constituent unit derived from an alkyl (meth)acrylate.

With regard to the alkyl (meth) acrylate, the alkyl group of the alkyl (meth) acrylate has, for example, 2 to 18 carbon atoms. The alkyl group may be linear or branched. The number of carbon atoms of the alkyl group is preferably from 2 to 14, more preferably from 3 to 12, still more preferably from 4 to 9. Specific examples of the alkyl (meth)acrylate include ethyl (meth)acrylate, n-butyl (meth)acrylate, s-butyl (meth)acrylate, t-butyl (meth)acrylate, isobutyl (meth)acrylate, n-pentyl (meth)acrylate, isopentyl (meth)acrylate, hexyl (meth)acrylate, heptyl (meth)acrylate, isoamyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth)acrylate, n-dodecyl (meth)acrylate, isomyristyl (meth)acrylate, n-tridecyl (meth)acrylate, n-tetradecyl (meth)acrylate, stearyl (meth)acrylate, and isostearyl (meth)acrylate. Of those, n-butyl (meth)acrylate or 2-ethylhexyl (meth) acrylate is preferred. Those monomers may be used alone or in combination thereof.

The content ratio of the constituent unit derived from an alkyl (meth)acrylate is preferably from 30 parts by weight to 100 parts by weight, more preferably from 85 parts by weight to 99.99 parts by weight, still preferably from 90 parts by weight to 99.95 parts by weight, particularly preferably from 95 parts by weight to 99 parts by weight with respect to 100 parts by weight of the acrylic polymer. When the content ratio falls within such ranges, a pressure-sensitive adhesive layer excellent in pressure-sensitive adhesive property can be formed.

In one embodiment, the acrylic polymer further has a constituent unit derived from a functional group-containing monomer . A monomer having any appropriate functional group may be used as the functional group-containing monomer. Specific examples of the functional group-containing monomer include a carboxyl group-containing monomer, a hydroxyl group-containing monomer, an amide group-containing monomer, and an amino group-containing monomer. When any such monomer is used, a pressure-sensitive adhesive layer excellent in heat resistance can be formed. The functional group-containing monomers may be used alone or in combination thereof.

A monomer having a polymerizable functional group having an unsaturated double bond, such as a (meth)acryloyl group or a vinyl group, and a carboxyl group may be used as the carboxyl group-containing monomer. Examples of the carboxyl group-containing monomer include (meth)acrylic acid, carboxyethyl (meth)acrylate, carboxypentyl (meth)acrylate, itaconic acid, maleic acid, fumaric acid, and crotonic acid. Of those, (meth) acrylic acid is preferred, and acrylic acid is particularly preferred.

A monomer having a polymerizable functional group having an unsaturated double bond, such as a (meth)acryloyl group or a vinyl group, and a hydroxyl group may be used as the hydroxyl group-containing monomer. Examples of the hydroxyl group-containing monomer include: hydroxyalkyl (meth)acrylates, such as 2-hydroxyethyl (meth)acrylate, 2-hydroxybutyl (meth)acrylate, 3-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, and 12-hydroxylauryl (meth)acrylate; and hydroxyethyl(meth)acrylamide, N-methylol(meth)acrylamide, and besides, (4-hydroxymethylcyclohexyl)methyl acrylate, N-methylol(meth)acrylamide, N-hydroxy(meth)acrylamide, allyl alcohol, 2-hydroxyethyl vinyl ether, 4-hydroxybutyl vinyl ether, and diethylene glycol monovinyl ether. Of those, hydroxyalkyl (meth)acrylates are preferred.

A monomer having a polymerizable functional group having an unsaturated double bond, such as a (meth)acryloyl group or a vinyl group, and an amide bond may be used as the amide group-containing monomer. Examples of the amide group-containing monomer include (meth)acrylamide, N-substituted amide-based monomers, such as N,N-dimethyl(meth)acrylamide, N,N-diethyl(meth)acrylamide, N,N-diethylmethacrylamide, N-isopropyl(meth)acrylamide, N-methoxymethyl(meth)acrylamide, N-butoxymethyl(meth)acrylamide, N-vinylcaprolactam, N-acryloylmorpholine, N-acryloylpiperidine, N-methacryloylpiperidine, and N-acryloylpyrrolidine, diacetone (meth)acrylamide, and N-vinylacetamide.

A monomer having a (meth)acryloyl group and an amino group may be used as the amino group-containing monomer. The amino group-containing monomer is preferably a monomer having a tertiary amino group. In addition, the tertiary amino group is preferably a tertiary aminoalkyl group. Examples of such tertiary amino group-containing monomer include an N,N-dialkylaminoalkyl(meth)acrylamide and an N,N-dialkylaminoalkyl (meth)acrylate. Specific examples of the tertiary amino group-containing monomer include N,N-dimethylaminoethyl(meth)acrylamide, N,N-dimethylaminopropyl(meth)acrylamide, N,N-diethylaminoethyl(meth)acrylamide, N,N-diethylaminopropyl(meth)acrylamide, N,N-dimethylaminoethyl (meth)acrylate, N,N-dimethylaminopropyl (meth)acrylate, N,N-diethylaminoethyl (meth)acrylate, and N,N-diethylaminopropyl(meth)acrylamide. In addition, as a monomer having a secondary amino group, there is given, for example, t-butylaminoethyl (meth)acrylate.

The content ratio of the constituent unit derived from a functional group-containing monomer is preferably from 0.01 part by weight to 15 parts by weight, more preferably from 0.05 part by weight to 10 parts by weight with respect to 100 parts by weight of the (meth)acrylic polymer.

The acrylic polymer may have a constituent unit derived from any appropriate other monomer as required. Examples of the other monomer include: aromatic ring-containing monomers, such as phenoxyethyl (meth)acrylate, benzyl (meth)acrylate, phenol ethylene oxide-modified (meth)acrylate, 2-naphthoethyl (meth)acrylate, 2-(4-methoxy-1-naphthoxy)ethyl (meth)acrylate, phenoxypropyl (meth)acrylate, phenoxydiethylene glycol (meth)acrylate, polystyryl (meth)acrylate, and styrene; vinyl ester-based monomers, such as vinyl acetate and vinyl propionate; and alkoxyalkyl (meth) acrylate-basedmonomers, such as methoxyethyl (meth)acrylate and ethoxyethyl (meth)acrylate. The content ratio of the constituent unit derived from the other monomer is preferably 55 parts by weight or less, more preferably 35 parts by weight or less, particularly preferably 30 parts by weight or less with respect to 100 parts by weight of the (meth)acrylic polymer.

The weight-average molecular weight of the acrylic polymer is preferably from 1,000,000 to 3,000,000, more preferably from 1,500,000 to 2,500,000, still more preferably from 1,700,000 to 2,500,000. When the weight-average molecular weight falls within such ranges, a pressure-sensitive adhesive layer excellent in heat resistance and pressure-sensitive adhesive strength can be obtained. The weight-average molecular weight refers to a value measured by gel permeation chromatography (GPC) and calculated in terms of polystyrene.

The pressure-sensitive adhesive may further contain any appropriate additive as required. Examples of the additive include a cross-linking agent, a pigment, a dye, a surfactant, a plasticizer, a tackifier, a surface lubricant, a leveling agent, a softener, an antioxidant, an age resistor, a light stabilizer, a UV absorber, a polymerization inhibitor, and an inorganic or organic filler. Examples of the cross-linking agent include an isocyanate-based cross-linking agent, an epoxy-based cross-linking agent, a peroxide-based cross-linking agent, a metal chelate-based cross-linking agent, and an oxazoline-based cross-linking agent. Of those, an isocyanate-based cross-linking agent is preferred. The content of the cross-linking agent is preferably 2 parts by weight or less, more preferably 1.5 parts by weight or less, still more preferably 1 part by weight or less with respect to 100 parts by weight of the acrylic polymer.

The thickness of the first pressure-sensitive adhesive layer is preferably from 0.1 µm to 100 µm, more preferably from 5 µm to 50 µm, still more preferably from 5 µm to 25 µm.

The refractive index of the first pressure-sensitive adhesive layer is from 1.42 to 1.60, more preferably from 1.47 to 1.58. When the refractive index falls within such ranges, an LED backlight excellent in waveguide efficiency of light and excellent in emission intensity can be obtained.

The light transmittance of the first pressure-sensitive adhesive layer is preferably from 85% to 99%, more preferably from 88% to 99%, still more preferably from 90% to 99%. In addition, the haze value of the first pressure-sensitive adhesive layer is preferably 5 or less, more preferably 3 or less, still more preferably 1 or less.

The first pressure-sensitive adhesive layer is preferably bonded to a light guide plate side in each of a light guide unit and an LED backlight. In one embodiment, the first pressure-sensitive adhesive layer is brought into close contact with the light guide plate directly or indirectly via a resin layer directly laminated on the light guide plate. In the light guide unit or the LED backlight, the pressure-sensitive adhesive strength of the first pressure-sensitive adhesive layer for a layer adjacent to the opposite side of the first pressure-sensitive adhesive layer to the low-refractive index layer is preferably 0.8 N/25 mm or more, more preferably 1 N/25 mm or more, still more preferably 1.5 N/25 mm or more. The upper limit of the pressure-sensitive adhesive strength is, for example, 30 N/25 mm. As used herein, the term "pressure-sensitive adhesive strength" refers to a pressure-sensitive adhesive strength measured under an environment at 23°C by a method in conformity with JIS Z 0237:2000 (bonding condition: 1 pass back and forth with a 2 kg roller, peel rate: 300 mm/min, peel angle: 180°).

### A-7. Second Pressure-sensitive Adhesive Layer

The second pressure-sensitive adhesive layer contains any appropriate pressure-sensitive adhesive. The pressure-sensitive adhesive preferably has transparency and optical isotropy. Specific examples of the pressure-sensitive adhesive include a rubber-based pressure-sensitive adhesive, an acrylic pressure-sensitive adhesive, a silicone-based pressure-sensitive adhesive, an epoxy-based pressure-sensitive adhesive, and a cellulose-based pressure-sensitive adhesive. Of those, a rubber-based pressure-sensitive adhesive or an acrylic pressure-sensitive adhesive is preferred. The acrylic pressure-sensitive adhesive described in the section A-4 may be used.

The thickness of the second pressure-sensitive adhesive layer is preferably from 0.1 µm to 100 µm, more preferably from 5 µm to 50 µm, still more preferably from 5 µm to 25 µm.

The second pressure-sensitive adhesive layer is preferably bonded to a flexible substrate (flexible printed circuit: FPC) in each of a light guide unit and an LED backlight. In one embodiment, the second pressure-sensitive adhesive layer is brought into close contact with the FPC directly or indirectly via a resin layer, an insulating layer, or the like directly laminated on the FPC. In the light guide unit or the LED backlight, the pressure-sensitive adhesive strength of the second pressure-sensitive adhesive layer for a layer adjacent to the opposite side of the second pressure-sensitive adhesive layer to the low-refractive index layer is preferably 0.5 N/25 mm or more, more preferably 0.7 N/25 mm or more, still more preferably 1.0 N/25 mm or more. The upper limit of the pressure-sensitive adhesive strength is, for example, 30 N/25 mm.

The second pressure-sensitive adhesive layer may be transparent, or may be non-transparent. In one embodiment, the second pressure-sensitive adhesive layer is transparent. When the second pressure-sensitive adhesive layer is transparent, its transmittance is preferably from 50% to 99%, more preferably from 60% to 99%, still more preferably from 70% to 99%. When the transmittance falls within such ranges, there can be obtained a film for an LED backlight, which can enable appropriate guiding of light, even in the case where light leakage occurs beyond the low-refractive index layer.

### A-8. Production Method for Film for LED Backlight

The film for an LED backlight may be produced by any appropriate method. For example, the low-refractive index layer may be formed on the base material by applying an application liquid for forming a low-refractive index layer containing predetermined particles (e.g., the fine porous particles of a silicon compound, preferably the pulverized product of a gelled silicon compound) onto the base material, followed by drying.

The application liquid for forming a low-refractive index layer contains any appropriate solvent. Examples of the solvent include isopropyl alcohol, ethanol, methanol, n-butanol, 2-butanol, isobutyl alcohol, and pentanol.

In one embodiment, the application liquid for forming a low-refractive index layer further contains a catalyst. A catalyst capable of promoting the chemical bonding of the particles is used as the catalyst. For example, when the fine porous particles of a silicon compound are used as the particles, a catalyst capable of promoting a dehydration condensation reaction of silanol groups of the silicon compound is used. Examples of the catalyst include: base catalysts, such as potassium hydroxide, sodium hydroxide, and ammonium hydroxide; and acid catalysts, such as hydrochloric acid, acetic acid, and oxalic acid. Of those, a base catalyst is preferred. The content ratio of the catalyst is preferably from 0.01 part by weight to 20 parts by weight, more preferably from 0.1 part by weight to 5 parts by weight with respect to 100 parts by weight of the particles in the application liquid for forming a low-refractive index layer.

Any appropriate method may be adopted as an application method for the application liquid for forming a low-refractive index layer. Examples of the application method include bar coater coating, air knife coating, gravure coating, gravure reverse coating, reverse roll coating, lip coating, die coating, and dip coating.

Any appropriate method may be adopted as a drying method for the application liquid for forming a low-refractive index layer. The drying method for the application liquid may be natural drying, drying by heating, or drying under reduced pressure. As heating means, there are given, for example, a hot air fan, a heating roll, and a far-infrared heater.

In the formation of the low-refractive index layer, the applied layer may be subjected to heating treatment. The heating treatment can promote bonding between the particles forming the low-refractive index layer. For example, when the fine porous particles of a silicon compound are used as the particles, a heating temperature is preferably 200°C or more. The drying step may double as the heating treatment.

The details of a formation method for the low-refractive index layer are described in, for example, JP 2017-47677 A, the description of which is incorporated herein by reference.

The first pressure-sensitive adhesive layer and the second pressure-sensitive adhesive layer may each be formed by any appropriate method. For example, the first pressure-sensitive adhesive layer and the second pressure-sensitive adhesive layer may each be formed by applying a pressure-sensitive adhesive by a method such as bar coater coating, air knife coating, gravure coating, gravure reverse coating, reverse roll coating, lip coating, die coating, or dip coating. In addition, the first pressure-sensitive adhesive layer and the second pressure-sensitive adhesive layer may each be formed by a method involving transferring a pressure-sensitive adhesive layer formed on a release liner. In addition, as required, the pressure-sensitive adhesive after its application may be irradiated with an active energy ray (preferably UV light) . The irradiation dose of an electron beam is preferably from 2 kGy to 100 kGy, more preferably from 2 kGy to 70 kGy, still more preferably from 5 kGy to 50 kGy.

### B. Light Guide Unit

As illustrated in FIG. **2 (a)** and FIG. **2(b)**, a light guide unit of the present invention includes the film **110** for an LED backlight and the light guide plate **120.** The film **110** for an LED backlight is arranged by being laminated on part of one surface of the light guide plate **120.** More specifically, the film **110** for an LEDbacklight is arranged by being bonded in the vicinity of the end surface **121** of the light guide plate **120** in its light guiding direction (end surface **121** on which a light source is to be arranged) . The film **110** for a LED backlight may be preferably bonded to the light guide plate **120** so as to cover part of one surface **122** of the light guide plate **120** in the light guiding direction **X** of the light guide plate **120,** and so as to cover the entirety of the one surface **122** of the light guide plate **120** in the direction **Y** perpendicular to the light guiding direction **X** in a plane including the light guiding direction **X.** The film **110** for an LED backlight may be bonded in such a manner that the light guide plate and the low-refractive index layer are arranged via the first pressure-sensitive adhesive layer. The film **110** for an LED backlight is preferably directly arranged on the light guide plate. In addition, when the film **110** for an LED backlight includes the base material, the film **110** for an LED backlight is preferably directly arranged on the light guide plate in such a manner that the low-refractive index layer is arranged inside (light guide plate side) with respect to the base material. The term "directly arranged" means that the film **110** for an LED backlight and the light guide plate **120** are arranged without any other layer arranged between the film **110** for an LED backlight and the light guide plate **120.** In addition, the surface of the light guide plate to which the film for an LED backlight is bonded corresponds to the surface of the light guide plate on the opposite side to its light emission surface when the light guide unit is applied to an LED backlight.

The film for an LED backlight may be arranged in such a manner that one end portion thereof is brought into contact with the end surface of the light guide plate, or may be arranged at a slight distance from the end surface of the light guide plate. When the film for an LED backlight is arranged at a distance from the end surface of the light guide plate, the distance by which the film for an LED backlight is separated from the light guide plate is preferably 5 mm or less, more preferably 3 mm or less, particularly preferably 1 mm or less.

A length **Lx** of the film for an LED backlight in the light guiding direction is preferably 10 mm or less, more preferably 8 mmorless, still more preferably 5 mm or less, particularly preferably 3 mm or less. The lower limit of the length **Lx** is, for example, 0.5 mm. A ratio **(Lx/L)** between the length **Lx** of the film for an LED backlight in the light guiding direction and a length **L** of the light guide plate in the light guiding direction is preferably from 1/3,000 to 1/10, more preferably from 1/1,000 to 1/20. In the present invention, light can be satisfactorily reflected in the vicinity of the entrance surface to enhance the emitted light intensity of the light guide plate as a whole.

The film for an LED backlight may be applied to a region of the light guide plate where light emission is not performed. The following are achievements of the present invention: the emitted light intensity of the light guide plate as a whole can be enhanced through use of the film for an LED backlight, which has an extremely small size; and an improvement in waveguide efficiency can be achieved through use of a member to be applied to the region where light emission is not performed.

Any appropriate material may be used as a material for forming the light guide plate as long as light radiated from the LED light source can be efficiently guided. Examples of the material for forming the light guide plate include an acrylic resin, a polycarbonate-based resin, and a cycloolefin-based resin. The thickness of the light guide plate is, for example, from 100 µm to 2,000 µm.

The refractive index of the light guide plate is preferably 1.4 or more, more preferably more than 1.45, still more preferably more than 1.45 and 2 or less, particularly preferably from 1.48 to 1.8.

A difference between the refractive index of the light guide plate and the refractive index of the low-refractive index layer is preferably 0.2 or more, more preferably 0.23 or more, still more preferably 0.25 or more. When the difference falls within such ranges, there can be obtained an LED backlight unit capable of satisfactorily reflecting light at the interface between the light guide plate and the film for an LED backlight, thereby being excellent in waveguide efficiency of light and excellent in emission intensity. In general, the refractive index of the light guide plate is higher than the refractive index of the low-refractive index layer.

### C. LED Backlight

FIG. **3** is a schematic cross-sectional view of an LED backlight according to one embodiment of the present invention. The LED backlight **200** may include the light guide unit **100** and the LED light source **130** arranged on the end surface **121** of the light guide plate **120** included in the light guide unit **100** on the side on which the film 110 for an LED backlight is arranged.

The thickness of the film for an LED backlight is preferably equal to or smaller than (thickness of LED light source-thickness of light guide plate). More specifically, the thickness of the film for an LED backlight is preferably from { (thickness of LED light source-thickness of light guide plate)×10%} to {(thickness of LED light source-thickness of light guide plate)×100%}, more preferably from {(thickness of LED light source-thickness of light guide plate)×30%} to { (thickness of LED light source-thickness of light guide plate)×100%}, still more preferably from { (thickness of LED light source-thickness of light guide plate)×50%} to { (thickness of LED light source-thickness of light guide plate)×100%}. When the thickness falls within such ranges, in the backlight unit including the LED light source, the positional relationship between the LED light source and the light guide plate can be appropriately adjusted. The thickness of the LED light source is generally from 200 µm to 5,000 µm.

The LED backlight may include any appropriate other member. In one embodiment, the LED backlight **200** may further include a reflective plate **140** arranged via an air layer on a surface of the light guide plate **120** on which the film **110** for an LED backlight is not arranged. In addition, a flexible substrate **150** for an LED may be arranged beneath the film **110** for an LED backlight (opposite side to the light guide plate **120**). The flexible substrate for an LED may include a colored layer (e.g., a white-colored ink layer) on its surface on the side of the film for an LED backlight. In addition, the LED backlight **200** may include a chassis **160** configured to receive the above-mentioned members.

### Examples

Now, the present invention is specifically described by way of Examples. However, the present invention is by no means limited to these Examples. Evaluation methods in Examples and Comparative Examples are as described below. In addition, the terms "part(s)" and "%" are by weight unless otherwise stated.

### <Evaluation Methods>

### (1) Refractive Index

A low-refractive index layer was cut into a size of 50 mm×50 mm, and the resultant was bonded to the front surface of a glass plate (thickness: 3 mm) via a pressure-sensitive adhesion layer. A central portion (diameter: about 20 mm) of the back surface of the glass plate was painted over with a black felt-tip pen to provide a sample prevented from reflection at the back surface of the glass plate. The sample was set in an ellipsometer (manufactured by J.A. Woollam Japan: VASE), and its refractive index was measured under the conditions of a wavelength of 500 nm and an incident angle of from 50° to 80°.

### (2) White Brightness

A white color was displayed on the entire screen of a liquid crystal display apparatus, and its front brightness (white brightness) wasmeasured (unit: cd/m²) with a conoscope (manufactured by Autronic-Melchers GmbH).

### (3) Hot Spot

A film for an LED backlight obtained in each of Example and Comparative Example was, as illustrated in FIG. 3, incorporated into an LED backlight (refractive index of light guide plate: 1.49, thickness of LED light source: 300 µm), and lightness unevenness of the emission surface of the light guide plate at a time when the LED light source was turned on was visually observed. A case in which uniform lighting was able to be performed was defined as acceptable ("○" in Table 1), and a case in which lightness unevenness and light leakage were able to be observed was defined as unacceptable ("×" in Table 1).

### [Production Example 1] Preparation of Application Liquid for Forming Low-refractive Index Layer

### (1) Gelation of Silicon Compound

0.95 g of MTMS serving as a precursor of a silicon compound was dissolved in 2.2 g of DMSO to prepare a mixed liquid A. To the mixed liquid A, 0.5 g of a 0.01 mol/L oxalic acid aqueous solution was added, and the mixture was stirred at room temperature for 30 minutes to hydrolyze MTMS. Thus, a mixed liquid B containing tris(hydroxy)methylsilane was produced.

0.38 g of 28 wt% ammonia water and 0.2 g of pure water were added to 5.5 g of DMSO, and then the mixed liquid B was further added. The mixture was stirred at room temperature for 15 minutes to perform gelation of tris(hydroxy)methylsilane. Thus, a mixed liquid C containing a gelled silicon compound was obtained.

### (2) Maturation Treatment

The mixed liquid C containing the gelled silicon compound prepared as described above was subjected as it was to maturation treatment by being incubated at 40°C for 20 hours.

### (3) Pulverization Treatment

Next, the gelled silicon compound subjected to maturation treatment as described above was crushed using a spatula into granules each having a size of from several mm to several cm. Then, 40 g of IBA was added to the mixed liquid C, and the whole was lightly stirred and then left to stand still at room temperature for 6 hours to decant the solvent and the catalyst in the gel. Similar decantation treatment was performed three times to perform solvent replacement, to thereby provide a mixed liquid D. Then, the gelled silicon compound in the mixed liquid D was subjected to pulverization treatment (high-pressure media-less pulverization). The pulverization treatment (high-pressure media-less pulverization) was performed by weighing 1.85 g of the gelled compound in the mixed liquid D' and 1.15 g of IBA into a 5 cc screw-capped vial and then pulverizing the contents under the conditions of 50 W and 20 kHz for 2 minutes through use of a homogenizer (manufactured by SMT Co., Ltd., product name: "UH-50").

As a result of the pulverization treatment, the gelled silicon compound in the mixed liquid D was pulverized, and thus the mixed liquid D' became a sol liquid of a pulverized product. A volume-average particle diameter indicating a variation in particle size of the pulverized product contained in the mixed liquid D' was found to be from 0.50 to 0.70 with a dynamic light scattering Nanotrac particle size analyzer (manufactured by Nikkiso Co., Ltd., model UPA-EX150) . Further, to 0.75 g of the sol liquid (mixed liquid C'), a solution of a photobase generator (Wako Pure Chemical Industries, Ltd.: product name: WPBG-266) in methyl ethyl ketone (MEK) at a concentration of 1.5 wt% and a solution of bis(trimethoxysilyl)ethane in MEK at a concentration of 5% were added at a ratio of 0.062 g:0.036 g to provide an application liquid for a low-refractive index layer.

### [Production Example 2] Production of First Pressure-sensitive Adhesion Layer

A four-necked flask with a stirring blade, a temperature gauge, a nitrogen gas inlet tube, and a condenser was loaded with 90.7 parts of butyl acrylate, 6 parts of N-acryloylmorpholine, 3 parts of acrylic acid, 0.3 part of 2-hydroxybutyl acrylate, and 0.1 part by weight of 2,2'-azobisisobutyronitrile serving as a polymerization initiator together with 100 g of ethyl acetate. While the contents were gently stirred, a nitrogen gas was introduced to perform nitrogen purge. After that, with the liquid temperature in the flask being kept around 55°C, a polymerization reaction was performed for 8 hours to prepare an acrylic polymer solution. With respect to 100 parts of the solid content of the resultant acrylic polymer solution, 0.2 part of an isocyanate cross-linking agent (CORONATE L manufactured by Nippon Polyurethane Industry Co., Ltd., tolylene diisocyanate adduct of trimethylolpropane), 0.3 part of benzoyl peroxide (NYPER BMT manufactured by Nippon Oil & Fats Co., Ltd.), and 0.2 part of γ-glycidoxypropylmethoxysilane (manufactured by Shin-Etsu Chemical Co., Ltd.: KBM-403) were blended to prepare an acrylic pressure-sensitive adhesive solution. Then, the acrylic pressure-sensitive adhesive solution was applied to one surface of a silicone-treated polyethylene terephthalate (PET) film (manufactured by Mitsubishi Polyester Film Corporation, thickness: 38 µm) so that a pressure-sensitive adhesive layer after drying had a thickness of 10 µm, and the applied solution was dried at 150°C for 3 minutes to form the first pressure-sensitive adhesive layer.

### [Production Example 3] Production of Second Pressure-sensitive Adhesive Layer

A four-necked flask with a stirring blade, a temperature gauge, a nitrogen gas inlet tube, and a condenser was loaded with 97 parts of butyl acrylate, 3 parts of acrylic acid, 1 part of 2-hydroxybutyl acrylate, and 0.1 part by weight of 2,2'-azobisisobutyronitrile serving as a polymerization initiator together with 100 g of ethyl acetate. While the contents were gently stirred, a nitrogen gas was introduced to perform nitrogen purge. After that, with the liquid temperature in the flask being kept around 55°C, a polymerization reaction was performed for 8 hours to prepare an acrylic polymer solution. With respect to 100 parts of the solid content of the resultant acrylic polymer solution, 0.5 part of an isocyanate cross-linking agent (CORONATE L manufactured by Nippon Polyurethane Industry Co., Ltd., tolylene diisocyanate adduct of trimethylolpropane), 0.2 part of benzoyl peroxide (NYPER BMT manufactured by Nippon Oil & Fats Co., Ltd.), and 0.2 part of γ-glycidoxypropylmethoxysilane (manufactured by Shin-Etsu Chemical Co., Ltd.: KBM-403) were blended to prepare an acrylic pressure-sensitive adhesive solution. Then, the acrylic pressure-sensitive adhesive solution was applied to one surface of a silicone-treated polyethylene terephthalate (PET) film (manufactured by Mitsubishi Polyester Film Corporation, thickness: 38 µm) so that a pressure-sensitive adhesive layer after drying had a thickness of 15 µm, and the applied solution was dried at 150°C for 3 minutes to form the second pressure-sensitive adhesive layer.

### [Example 1]

The application liquid for a low-refractive index layer prepared in Production Example 1 was applied to an acrylic resin film (thickness: 20 µm) serving as a base material, and was dried to provide a laminate in which a low-refractive index layer (refractive index: 1.18) having a thickness of 850 nm was arranged on one surface of the base material. The low-refractive index layer was subjected to UV (300 mJ) irradiation, and then the pressure-sensitive adhesive layer of Production Example 2 (first pressure-sensitive adhesive layer) and the pressure-sensitive adhesive layer of Production Example 3 (second pressure-sensitive adhesive layer) were transferred onto the low-refractive index layer side and base material side of the laminate, respectively, followed by aging at 60°C for 20 hours, to provide a film for an LED backlight (first pressure-sensitive adhesive layer/low-refractive index layer/base material/second pressure-sensitive adhesive layer).

The resultant film for an LED backlight was subjected to the evaluations (2) and (3). The results are shown in Table 1.

### [Comparative Example 1]

The pressure-sensitive adhesive layer of Production Example 2 was transferred onto one surface of an acrylic resin film (thickness : 20 µm) serving as a base material, and the pressure-sensitive adhesive layer of Production Example 3 was transferred onto the other surface, followed by aging at 60°C for 20 hours, to provide a film for an LED backlight (first pressure-sensitive adhesive layer/base material/second pressure-sensitive adhesive layer).

The resultant film for an LED backlight was subjected to the evaluations (2) and (3). The results are shown in Table 1.

**Table 1**

| | Example 1 | Comparative Example 1 |
|---|---|---|
| Configuration | First pressure-sensitive adhesive layer/low-refractive index layer/base material/second pressure-sensitive adhesive layer | First pressure-sensitive adhesive layer/base material/second pressure-sensitive adhesive layer |
| White brightness | 491 | 443 |
| Hot spot | ○ | × |

As apparent from Table 1, the use of the film for an LED backlight of the present invention can provide an LED backlight capable of efficiently guiding entering light.

### Reference Signs List

- **10**: first pressure-sensitive adhesive layer
- **20**: low-refractive index layer
- **30**: base material
- **40**: second pressure-sensitive adhesive layer
- **100**: light guide unit
- **110**: film for LED backlight
- **130**: LED light source
- **200**: LED backlight

## Claims

1. A film for an LED backlight, comprising:
a low-refractive index layer; and
a first pressure-sensitive adhesive layer arranged on at least one side of the low-refractive index layer,
wherein the low-refractive index layer has a refractive index of 1.25 or less.

2. The film for an LED backlight according to claim 1, wherein the low-refractive index layer is configured to be a porous body having voids.

3. The film for an LED backlight according to claim 2, wherein the low-refractive index layer has a void ratio of 35 vol% or less.

4. The film for an LED backlight according to any one of claims 1 to 3, wherein the film for an LED backlight has a thickness of 100 µm or less.

5. A light guide unit, comprising:
the film for an LED backlight of any one of claims 1 to 4; and
a light guide plate,
wherein the film for an LED backlight is
arranged by being bonded in a vicinity of an end surface of the light guide plate in a light guiding direction thereof, and
bonded to the light guide plate so as to cover part of one surface of the light guide plate in the light guiding direction of the light guide plate, and so as to cover an entirety of the one surface of the light guide plate in a direction perpendicular to the light guiding direction in a plane including the light guiding direction.

6. An LED backlight, comprising:
the light guide unit of claim 5; and
an LED light source arranged on the end surface of the light guide plate on a side on which the film for an LED backlight is arranged.

7. The LED backlight according to claim 6, wherein the film for an LED backlight has a thickness of from {(thickness of LED light source-thickness of light guide plate)×50%} to {(thickness of LED light source-thickness of light guide plate)×100%}.
